# EUROPEAN PATENT SPECIFICATION

(11) **EP 3 696 843 B1**
(45) Date of publication and mention of the grant of the patent: **01.05.2024**
(21) Application number: 19156562.1
(22) Date of filing: 12.02.2019
(51) Int. Cl.: H01H 50/02

(54) **HOUSING ASSEMBLY FOR ENCASING AN ELECTROMAGNETIC COMPONENT AND A METHOD FOR ASSEMBLING A HOUSING**
GEHÄUSEANORDNUNG ZUR UMMANTELUNG EINER ELEKTROMAGNETISCHEN KOMPONENTE UND VERFAHREN ZUR MONTAGE EINES GEHÄUSES
ENSEMBLE BOÎTIER POUR ENFERMER UN COMPOSANT ÉLECTROMAGNÉTIQUE ET PROCÉDÉ D'ASSEMBLAGE D'UN BOÎTIER

(43) Date of publication of application: 19.08.2020
(73) Proprietor: TE Connectivity Austria GmbH, 3830 Waidhofen an der Thaya (AT)
(72) Inventor: Gutmann, Markus, 3531 Niedernondorf (AT); Harrer, Philipp, 3822 Karlstein an der Thaya (AT)
(74) Representative: Grünecker Patent- und Rechtsanwälte PartG mbB

(56) References cited:
- US-A- 5 289 144
- US-A1- 2009 114 514
- US-A9- 2016 347 495

## Description

The invention relates to a housing assembly for encasing an electromagnetic component such as a relay and a method for assembling a housing.

Such housing assemblies are often subjected to high inside pressure, which may occur due to high ambient and/or operating temperatures. Furthermore, fast temperature changes in combination with humidity inside the housing assembly may also increase the inside pressure. The inside pressure may deform and/or damage the housing.

An illuminated switch device is disclosed in US 2009/0114514 A1. The switch device includes a casing with an open upper side that has a partition wall formed on the inner bottom thereof, light sources that are provided on the inner bottom in a plurality of regions partitioned by the partition wall. The switch device further comprises an operating body that includes an outer housing and a light-shielding wall which divides a space surrounded by the outer housing.

A bin having an interference fit divider is disclosed in US 2016/0347495 A9.

US 5,289,144 A deals with a relay that comprises a flat base. On one end of the base a motor unit is mounted and on the other end of the base a contact arrangement is mounted. A partition wall separates contact arrangement and motor unit from one another.

Therefore, it is an objective of the invention to provide a housing assembly and a method for assembling a housing with increased durability.

The invention solves the above-mentioned problem by providing a housing assembly for encasing an electromagnetic component such as a relay. The housing assembly comprises a housing part and at least one bulkhead wall, the at least one bulkhead wall being configured to be inserted into the housing part in an insertion direction and, in an inserted state, extending from one wall section of the housing to an opposite wall section along a horizontal direction. The housing assembly further comprises a locking sub-assembly, which is configured to lock the at least one bulkhead wall to the housing part in a direction parallel to the horizontal direction.

The above-mentioned objective is further solved by a method for assembling a housing comprising the steps of inserting at least one bulkhead wall in an insertion direction into a housing part, the at least one bulkhead wall extending from one wall section of the housing part to an opposite wall section of the housing part along a horizontal direction, and locking the at least one bulkhead wall to the housing part in a direction at least parallel to the horizontal direction.

With the inventive housing assembly and method for assembling a housing, the locking sub-assembly may prevent an expansion of the housing assembly due to high inside pressure. The locking of movement in the horizontal direction is prevented by the locking sub-assembly increasing the overall durability of the housing assembly.

A further object of the invention is to further increase the sealing properties of the housing assembly and locking strength.

According to the invention, this is achieved when a glue transport channel is provided in the inserted state, the glue transport channel opening towards an outside of the housing assembly and extending to the locking sub-assembly. Hence, a glue layer may be formed on the inside of the housing assembly which further increases the sealing properties of the housing assembly and locking strength

The invention can be further improved by the following features, which are independent from one another with respect to their respective technical effects and which can be combined arbitrarily.

According to a first embodiment of the invention, the locking sub-assembly may transmit forces parallel to the horizontal direction. Thus, the locking sub-assembly may further counteract forces caused by high inside pressure.

The horizontal direction may be essentially perpendicular to the insertion direction.

For further increasing the durability of the housing assembly and further strengthening the lock, the locking sub-assembly may comprise at least two overlapping protrusions. The at least two protrusions may overlap parallel to the horizontal direction creating an interlock, which prevents movement parallel to the horizontal direction. The at least two overlapping protrusions may abut each other. Alternatively, a gap may be provided between the at least two overlapping protrusions, the gap being adapted to receive a glue for further sealing and adhesively strengthening the locking sub-assembly.

The locking sub-assembly may provide at least one rail guide for guiding the at least one bulkhead wall in the insertion direction, the at least one rail guide extending in the insertion direction. Hence, the insertion of the at least one bulkhead wall may be facilitated. The at least one rail guide may particularly be configured to allow relative sliding within, between housing part and bulkhead wall in the insertion direction and at least block movement parallel to the horizontal direction. Hence, the rail guide may guide the insertion of the at least one bulkhead wall into the housing part and further prevent a deformation of the housing part.

The at least one rail guide may also block relative movement of the housing part and at least one bulkhead wall perpendicular to the horizontal direction and insertion direction. Hence, the locking sub-assembly may further secure the positioning of the at least one bulkhead wall relative to the housing part.

The at least one rail guide may comprise at least two ribs distanced from one another and forming a notch between them. The at least two rail guides may protrude parallel to the horizontal direction and extend along the insertion direction. The at least two ribs may be distanced from one another perpendicular to the horizontal direction and insertion direction.

At least one of the at least two ribs may comprise an undercut, which is adapted to receive a tongue of the locking sub-assembly forming a positive fit parallel to the horizontal direction.

At least two rail guides may be provided on opposing sides of the locking sub-assembly. The at least two rail guides may be arranged on each of the two opposing wall sections of the housing part. The at least one bulkhead wall may be engaged to the rail guides on each side. Hence, the locking sub-assembly may be formed directly by the at least one bulkhead wall and the housing part. Thus, additional separate parts for the locking sub-assembly can be avoided, reducing the production costs.

The at least one rail guide may be preferably formed integrally with the housing part. The housing part may be formed as an injection molded component, allowing for an easy and cost effective production on a mass scale. In particular, the at least two ribs may be formed integrally with the housing part. One of the two ribs may comprise a higher material thickness than the other rib. Preferably, the rib, which comprises an undercut may comprise a higher material thickness than the other rib. Hence, the rib comprising the undercut may be further stabilized and the locking sub-assembly may compensate higher forces in the horizontal direction.

A side edge of the bulkhead wall facing the wall section may be at least partly arranged in the notch between the two ribs in the inserted state. The side edge may comprise the tongue that extends into the undercut in the inserted state.

For increasing the locking strength of the locking sub-assembly in the horizontal direction, a front and back of the at least one bulkhead wall may be engaged by the locking sub-assembly. For example, two tongues may extend in opposing directions at the side edge essentially perpendicular to the insertion direction and horizontal direction. Each tongue may be adapted to engage an undercut of the ribs in the inserted state, increasing the overall overlapping surface area of the locking sub-assembly and consequently the strength of said locking sub-assembly.

The side edge of the bulkhead wall may comprise an essentially L-shaped or T-shaped cross section in a plane perpendicular to the insertion direction. The at least one guiding rail may be complementarily formed, so that a positive fit with a large overlapping surface area may be achieved, locking relative movement of the at least one bulkhead wall and housing part at least parallel to the horizontal direction. Preferably, the locking sub-assembly may be adapted to at least lock a relative movement at least parallel to the horizontal direction and perpendicular to the insertion and horizontal direction.

For a particularly strong interlock, the locking sub-assembly may comprise a dovetail joint. Preferably, the side edge of the at least one bulkhead wall may comprise a dovetail-shaped cross-section in a plane perpendicular to the insertion direction. An interlocking dovetail joint may provide a large contacting surface area. In particular, when adding glue between the interlocking components the large contacting surface area may strongly increase the strength of the joint.

The housing part and the bulkhead wall may be dimensioned to form a press-fit connection with one another. Thus, a cost efficient housing assembly may be provided that can be easily produced and assembled. However, more preferably a glue layer may be provided between the housing part and bulkhead wall, further sealing the housing assembly and strengthening the locking sub-assembly.

The at least one bulkhead wall may close the housing assembly in the inserted state, completely encasing the electrical component.

According to another advantageous embodiment, the at least one bulkhead wall may be part of a further housing part, the further housing part being adapted to being at least partially received in the housing part. The further housing part may form a base closing the housing assembly in the inserted state. The further housing part and the at least one bulkhead wall may be formed integrally with one another as a monolithic component. The electrical component may be formed on the further housing part, the further housing part serving as a base for the electrical component.

The at least one bulkhead wall may separate parts of the electrical component from one another. In the case of a relay, the at least one bulkhead wall may, for example, separate an electromagnetic coil from contact springs.

In the inserted state, the at least one bulkhead wall may preferably be arranged in a central portion of the housing part perpendicular to the insertion direction and horizontal direction. The central portion is usually most affected by high inside pressure, causing the wall section of the housing part to be deflected towards the outside.

The housing assembly may preferably be hermetically sealed in the inserted state. Thus, creating an airtight housing assembly and protecting the encased electrical component from water vapors and/or other foreign bodies. Thus, maintaining proper functionality and reliability of the electrical component. The locking sub-assembly may further increase the reliability of the hermetic sealed housing assembly by preventing the sealing from becoming cracked due to high inside pressure inside the housing assembly, pushing the wall sections of the housing part away from one another.

The housing assembly may be hermetically sealed by applying glue, such as a sealing epoxy in the inserted state. The glue may preferably be applied on an outside of the housing assembly, adhesively bonding the components of the housing assembly together and locking a movement at least in the insertion direction.

In a further advantageous embodiment, the further housing part may be completely inserted in the housing part in the inserted state. The further housing part may comprise at least one recess for receiving the glue. The recess may preferably be formed on an outside surface of the further housing part, facing away from the housing part. The recess may extend to at least one wall section of the housing part in the inserted state so that the glue filled in the recess adhesively bonds the further housing part to the at least one wall section and may hermetically seal the housing assembly.

According to the invention, a glue transport channel is provided in the inserted state. The glue transport channel opens towards an outside of the housing assembly and extends to the locking sub-assembly. Hence, a glue layer may be formed on the inside of the housing assembly further increasing the sealing properties of the housing assembly and locking strength. Preferably, the glue transport channel may open towards the outside at least one of the recesses.

The glue transport channel may be formed as a groove on the housing part. The groove may comprise sharp edges. Thus, the glue transport channel may transport the glue via capillary action into the inside of the housing assembly.

To further increase the strength of the locking sub-assembly and allow insertion of glue into the locking sub-assembly in the inserted state, the locking sub-assembly may form a further glue transport channel, the further glue transport channel being connected to the glue transport channel. In particular, the further glue transport channel may continue the glue transport channel. Hence, glue may be added to the locking sub-assembly adhesively bonding the interlocking components with one another. This may further prevent damage to the locking sub-assembly due to vibrations or shock. The glue averts relative movement and thus abrasion of the interlocking components.

The further glue transport channel may particularly be formed between the housing part and the at least one bulkhead wall. Thus, when filled with glue the housing part and the at least one bulkhead wall may be bonded by the glue. Preferably, the further transport channel may be formed as a further groove on the wall section of the housing part. The further groove having sharp edges, so that the glue may be transported via capillary action. The further transport channel may be formed by the notch between the two protruding ribs of the locking sub-assembly.

However, it should be noted that the glue may also be transported through the glue channel and/or the further glue channel by pushing the glue through the channel with pressure, e.g. air pressure.

The glue channel and the further glue channel may be arranged in planes parallel to one another and be arranged in a staggered formation in the insertion direction.

At least either the glue transportation channel or the further glue transportation channel, preferably both, may be filled with glue. The glue can be filled before the at least one bulkhead wall is inserted into the housing part. However, when applying the glue before insertion of the at least one bulkhead wall into the housing part the glue may solidify too quickly or may be displaced creating a non-uniform adhesive layer between the at least one bulkhead wall and the housing part. Hence, the glue may be preferably filled into the glue transport channel and/or further glue transport channel after insertion of the bulkhead wall into the housing part.

In the following, the housing assembly according to the invention is explained in greater detail with reference to the accompanying drawings, in which exemplary embodiments are shown.

In the figures, the same reference numerals are used for elements which correspond to one another in terms of their function and/or structure.

According to the description of the various aspects and embodiments, elements shown in the drawings can be omitted if the technical effects of those elements are not needed for a particular application, and *vice versa*: i.e. elements that are not shown or described with reference to the figures but are described above can be added if the technical effect of those particular elements is advantageous in a specific application.

In the figures:
- Fig. 1: shows a schematic cut view of an exemplary embodiment of a housing assembly according to the invention;
- Fig. 2: shows a schematic enhanced view of a locking sub-assembly shown in Fig. 1;
- Fig. 3: shows a schematic cut view of an L-shaped locking sub-assembly;
- Fig. 4: shows a schematic cut view of a dovetail-shaped locking sub-assembly;
- Fig. 5: shows a schematic cut view of a T-shaped locking sub-assembly;
- Fig. 6: shows a schematic perspective view of a bulkhead wall as part of a further housing part according to an exemplary embodiment of the invention;
- Fig. 7: shows a schematic perspective view of the inventive housing assembly in an inserted state;
- Fig. 8: shows a schematic enhanced view of a circled area in Fig. 7; and
- Fig. 9: shows a schematic cut view of the housing assembly shown in Figs. 7 and 8.

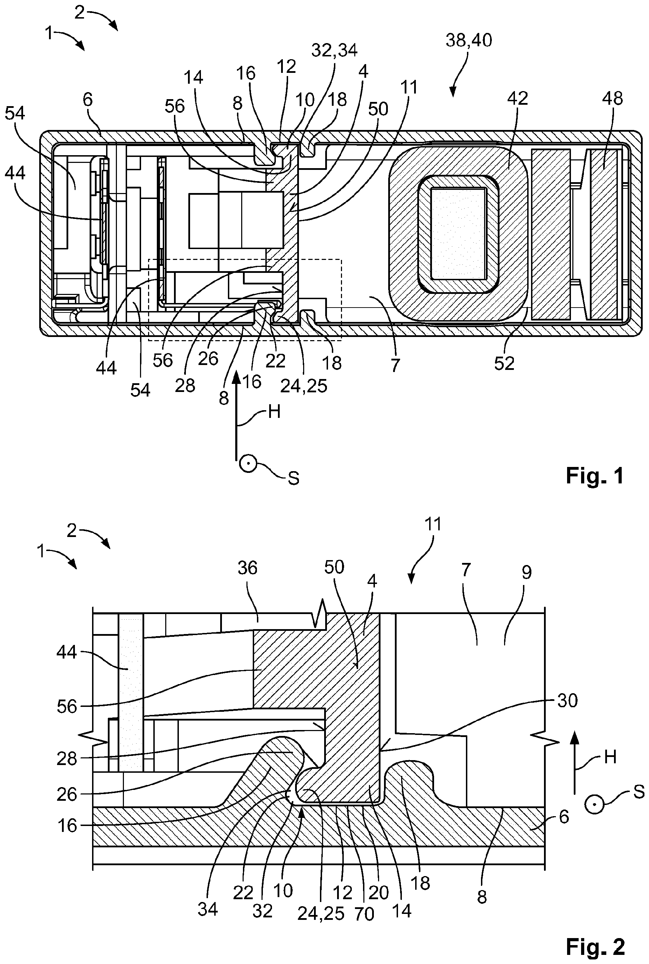

In Fig. 1 an exemplary embodiment of the housing assembly 1 is shown in a cut view. The housing assembly 1 is shown in an inserted state 2, in which at least one bulkhead wall 4 is inserted in an insertion direction S into a housing part 6.

In the inserted state 2 the bulkhead wall 4 extends from one wall section 8 to an opposite wall section 8 of the housing part 6 in a horizontal direction H, which is preferably arranged essentially perpendicular to the insertion direction S. The bulkhead wall 4 may preferably be arranged essentially perpendicular to the wall sections 8. A locking sub-assembly 10 is provided that is configured to lock the bulkhead wall to the housing part 6 in a direction essentially parallel to the horizontal direction H.

The bulkhead wall 4 may be arranged in a central portion 11 of the housing part 6 in the inserted state 2, the central portion 11 being in the centre of the housing part 6 perpendicular to the insertion direction S and horizontal direction H. The central portion 11 is usually the area of the housing part 6 with the largest deformation due to the high inside pressure. Therefore, the bulkhead wall 4 may preferably be arranged in said central portion 11 to prevent the deformation. However, depending on the size of the housing assembly 1, the bulkhead wall 4 may also be arranged in different portions or more than one bulkhead wall 4 may be provided distanced from one another perpendicular to the insertion direction S and horizontal direction H.

The locking sub-assembly 10 may comprise at least one rail guide 12, which extends along the insertion direction S. The rail guide 12 is formed integrally with the wall section 8 and is adapted to engage a side edge 14 of the bulkhead wall 4.

The rail guide 12 may be formed by two ribs 16, 18 jutting out from the wall section 8 and extending along the insertion direction S. The two ribs 16, 18 may be distanced from one another perpendicular to the insertion direction S and horizontal direction H forming a notch 20 between them. The side edge 14 is adapted to be slidingly inserted into the notch 20. The opposing wall section 8 is also formed with a complementary rail guide 12 so that the bulkhead wall 4 may be engaged to the housing part 6 at both sides in the horizontal direction H. Hence, the locking sub-assembly 10 may comprise an engagement between bulkhead wall 4 and housing part 6 at either side in the horizontal direction H.

Since the locking sub-assembly 10 comprises an essentially symmetric construction, the reference numerals are only shown on one of the two sides.

The locking sub-assembly 10 is shown in greater detail in Fig. 2 showing an enhanced image of the circled area in Fig. 1.

In order to form a positive interlock, at least one of the ribs 16 may form an undercut 22 in which a protrusion 24, e.g. a tongue 25 of the bulkhead wall 4 may be inserted in the inserted state 2. The undercut 22 may be formed by having the rib 16 extending obliquely from the wall section 8 towards the bulkhead wall 4. Alternatively, the rib 16 may comprise a protrusion 26 extending towards the bulkhead wall 4 and overlapping with the protrusion 24 in the horizontal direction H. The overlapping protrusions 24, 26 may form a positive fit blocking relative movement of the housing part 6 and bulkhead wall 4 at least parallel to the horizontal direction.

The components of the locking sub-assembly 10 may be dimensioned to form a press-fit connection in the inserted state 2. Preferably, however, a gap 32 may be provided between the interlocking parts, i.e. the ribs 16, 18 of the rail guide 12 and the side edge 14 of the at least one bulkhead wall 4. The gap 32 may be filled with glue 34, e.g. a sealing epoxy, adhesively bonding the interlocking parts to one another and further strengthening the locking sub-assembly 10. When the glue 34 is hardened, the locking sub-assembly 10 may in particular further lock relative movement in the insertion direction S.

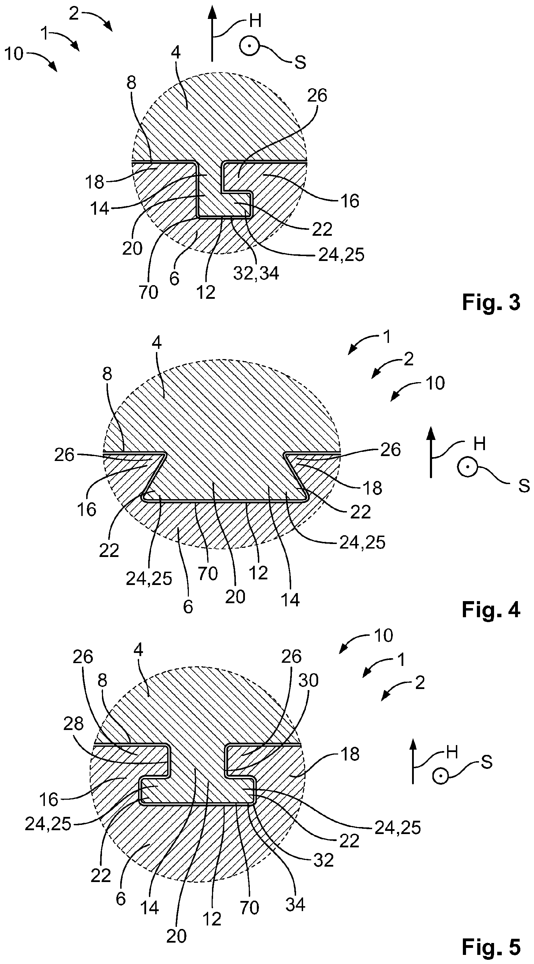

Other forms of the interlock between at least one bulkhead wall 4 and housing part 6 are shown in Figs. 3 to 5. The interlock may be L-shaped, T-shaped or dovetail-shaped. In particular, with a T-shaped or dovetail-shaped interlock a front 28 and a back 30 of the at least one bulkhead wall 4 may be engaged by the locking sub-assembly. Hence, a large overlapping surface area may be achieved further strengthening the interlock. The locking sub-assembly may also be further strengthened by adding the glue.

In the figures, it is shown that the rail guide 12 is formed on the housing part 6 and the bulkhead wall comprises the complementary formed protrusion 24 being adapted to be received in the inserted state 2. However, it should be noted that it could also be the other way around, i.e., the side edge 14 of the bulkhead wall 4 comprises a rail guide 12 and the housing part 6 a complementary formed protrusion 24 adapted to be received in the rail guide 12.

The at least one bulkhead wall 4 may be part of a further housing part 7, the further housing part 7 being adapted to be received in the housing part 6 in the inserted state 2. The further housing part 7 may comprise a base 9 being adapted to close an opening 13 of the housing part 6 for receiving the at least one bulkhead wall 4. The further housing part 7 and the at least one bulkhead wall 4 may be formed integrally with one another as a monolithic component 36.

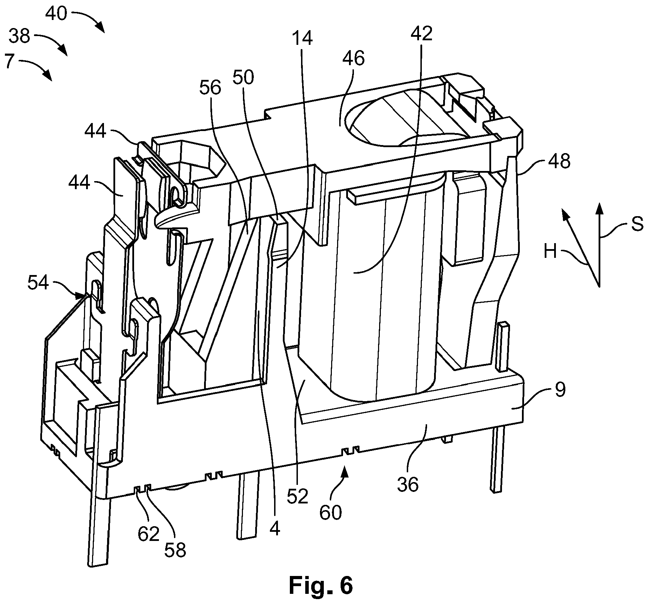

The further housing part 7 is shown in a schematic perspective view in Fig. 6.

The further housing part 7 may hold an electrical component 38, particularly a relay 40. The relay 40 comprises an electromagnetic coil 42 and two contact springs 44, which are arranged opposite to one another. One of the two contact springs 44 is connected to a drive element 46, which is further coupled to an armature 48 that is adapted to be moved by the electromagnetic coil 42. The drive element 46 thus moves the contact spring towards the other contact spring 44 when the electromagnetic coil is powered. The drive element 46 is arranged in the insertion direction S above the bulkhead wall 4 and extends from the armature 48 perpendicular to the insertion direction S and horizontal direction H to the contact spring 44. The drive element 46 is preferably distanced from a free end 50 of the bulkhead wall 4 so that the bulkhead wall 4 is not affected by the movement of the drive element 4.

The bulkhead wall 4 is preferably arranged at a central portion of the further housing part 7, separating two chambers 52, 54. One chamber 52 holds the electromagnetic coil 42 and the armature 48, while the other chamber 54 features the contact springs 44.

The bulkhead wall 4 extends in the insertion direction S from the base 9. To further stabilize the bulkhead wall 4, stabilizing posts 56 are formed on a surface of the bulkhead wall 4 extending in the horizontal direction H. Two stabilizing posts 56 are arranged distanced from one another in the horizontal direction H having an increased material thickness and taper towards the surface in the insertion direction S. The stabilizing posts 56 may particularly prevent relative movement of the bulkhead wall to the further housing part 7 due to shock or vibrations. Thus, further increasing the strength of the bulkhead wall 4 and the reliability of the locking sub-assembly 10.

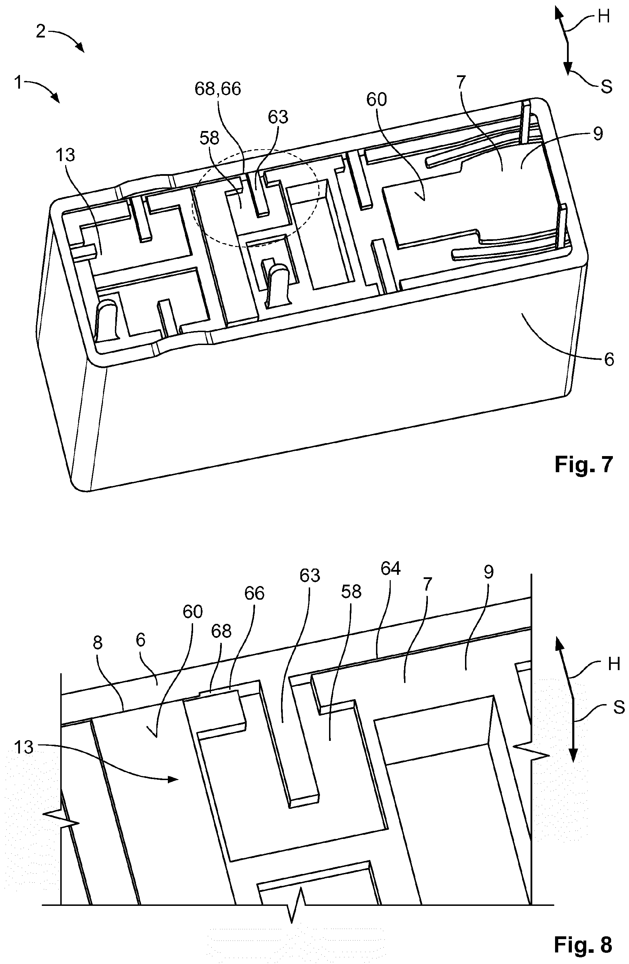

The further housing part 7 comprises various recesses 58 that are opened towards the outer circumference at the base 9. The recesses 58 are shown more clearly in Figs. 7 and 8. Fig. 7 shows a schematic perspective view of the housing assembly 1 in the inserted state 2, wherein a bottom surface 60 facing away from the housing part 6 of the further housing part 7 is visible.

As can be seen in Fig. 7 a plurality of recesses 58 are formed on the bottom surface 60 of the further housing part 7. Each recess 58 comprises at least one furrow 62, which opens towards the outer circumference of the bottom surface 60. The furrows 62 each border a guiding rib 63 for guiding glue 34 into the furrows 62. The recesses 58 and the guiding ribs 62 preferably comprise sharp edges, therefore acting as a capillary guiding the glue 34.

In the inserted state 2, the furrows 62 open the inner circumference of the housing part's 6 opening 13. Consequently, the furrows 62 are adapted to guide the glue 34 into slots 64 between the circumferences. By applying a sealing glue, e.g. a sealing epoxy, the housing assembly 1 may be hermetically sealed.

Fig. 8 shows an enhanced view of a recess 58 marked in Fig. 7 with a circle.

As can be seen in Fig. 8, a groove 66 is formed on the wall section 8 of the housing part 6 and in the inserted state 2 a furrow 62 of the recess 58 opens into the groove 66.

The groove 66 comprises sharp edges and extends in the insertion direction S forming a glue transport channel 68. Due to the sharp edges the glue may be sucked into the housing assembly between wall section 8 and further housing part 7 in the inserted state 2 further sealing the housing assembly 1.

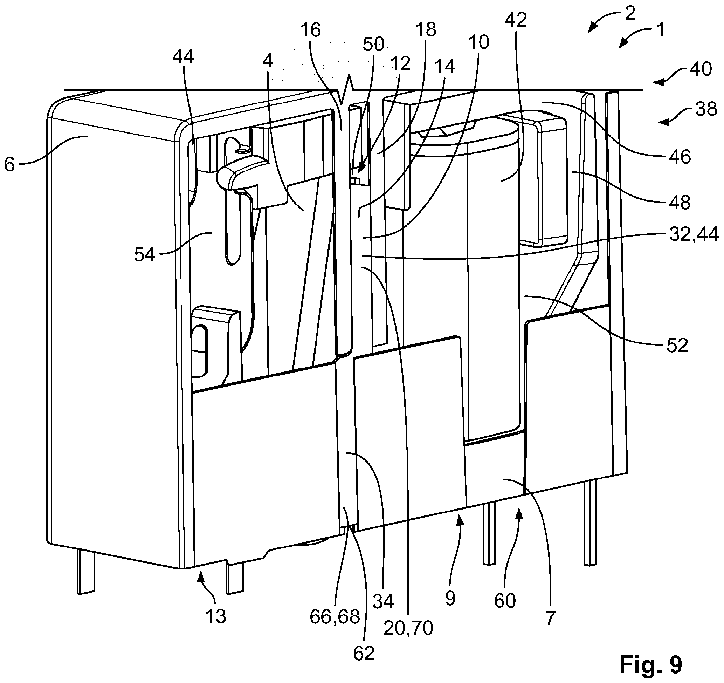

Fig. 9 shows a schematic perspective view of the housing assembly 1 according to an exemplary embodiment of the invention in the inserted state 2. The wall section 8 has been removed to allow insight into the inside of the housing assembly 1 in the inserted state 2. As can be seen, the glue transport channel 68 is filled with glue 34. The glue transport channel 68 extends in the insertion direction S and abuts one of the ribs 16, 18. The abutting rib 16 redirects the glue 34 into the notch 20 of the rail guide 12. Thus, the locking sub-assembly 10 forms a further glue transport channel 70 that continues the glue transport channel 68. The further glue transport channel 70 is bordered by the ribs 16, 18 and extends in the insertion direction S. Therefore, the glue 34 may be sucked between the side edge 14 of the bulkhead wall 4 and the rail guide 12, particularly via capillary action.

The glue 34 may be filled into the glue transport channel 68 and/or further glue transport channel 70 before the insertion of the bulkhead wall 4. However, the glue 34 may solidify too quickly or may be displaced during the insertion creating a non-uniform adhesive layer between the at least one bulkhead wall 4 and the housing part 6. Hence, the glue 34 may preferably be filled into the glue transport channel 68 and/or further glue transport channel 70 after insertion of the bulkhead wall 4 into the housing part 6.

The locking sub-assembly 10 counteracts an expansion of the housing part 6 in the horizontal direction H, due to occurring high inside pressure in the housing assembly 1. In particular, in hermetically sealed housing assemblies 1 the locking sub-assembly 10 reduces the shear-off forces on the sealing material significantly. Therefore, the inventive housing assembly 1 is more reliable and has a high durability.

### REFERENCE NUMERALS

- 1: housing assembly
- 2: inserted state
- 4: bulkhead wall
- 6: housing part
- 7: further housing part
- 8: wall section
- 9: base
- 10: locking sub-assembly
- 11: central portion
- 12: rail guide
- 13: opening of the housing part
- 14: side edge
- 16: rib
- 18: rib
- 20: notch
- 22: undercut
- 24: protrusion
- 25: tongue
- 26: protrusion
- 28: front
- 30: back
- 32: gap
- 34: glue
- 36: monolithic component
- 38: electrical component
- 40: relay
- 42: electromagnetic coil
- 44: contact springs
- 46: drive element
- 48: armature
- 50: free end
- 52: chamber with electromagnetic coil
- 54: chamber with contact springs
- 56: stabilizing post
- 58: recess
- 60: bottom surface
- 62: furrow
- 63: guiding rib
- 64: slot
- 66: groove
- 68: glue transport channel
- 70: further glue transport channel
- H: horizontal direction
- S: insertion direction

## Claims

1. Housing assembly (1) configured to encase an electrical component (38) such as a relay (40), comprising a housing part (6) and at least one bulkhead wall (4),
the at least one bulkhead wall (4) being configured to be inserted into the housing part (6) in an insertion direction (S) and, in an inserted state (2), extending from one wall section (8) of the housing part (6) to an opposite wall section (8) along a horizontal direction (H),
**characterized in that** the housing assembly (1) comprises a locking sub-assembly (10), which is configured to lock the at least one bulkhead wall (4) to the housing part (6) at least in a direction parallel to the horizontal direction (H)
and **in that** in the inserted state (2) at least one glue transport channel (68) is provided, the at least one glue transport channel (68) opening towards an outside of the housing assembly (1) and extending to the locking sub-assembly (10).

2. Housing assembly (1) according to claim 1, wherein the locking sub-assembly (10) comprises at least two overlapping protrusions (24, 26), which overlap in the horizontal direction (H).

3. Housing assembly (1) according to claim 1 or 2, wherein the locking sub-assembly (10) provides at least one rail guide (12), which extends in the insertion direction (S), for guiding the at least one bulkhead wall (4).

4. Housing assembly (1) according to claim 3, wherein the at least one rail guide (12) is configured to allow relative sliding within, between the housing part (6) and the at least one bulkhead wall (4) in the insertion direction (S) and to block movement at least parallel to the horizontal direction (H).

5. Housing assembly (1) according to claim 3 or 4, wherein the rail guide (12) comprises at least two ribs (16, 18) distanced from one another perpendicular to the insertion direction (S) and horizontal direction (H) and forming a notch (20) between them.

6. Housing assembly (1) according to claim 5, wherein at least one of the at least two ribs (16) forms an undercut (22) adapted to be engaged by the protrusion (24) in the inserted state (2).

7. Housing assembly (1) according to any one of claims 1 to 6, wherein the at least one bulkhead wall (4) is part of a further housing part (7), which is adapted to be at least partly received in the housing part (6).

8. Housing assembly (1) according to any one of claims 1 to 7, wherein in the inserted state (2) the housing assembly (1) is hermetically sealed.

9. Housing assembly (1) according to one of claims 1 to 8, wherein the at least one glue transport channel (68) is formed as a groove (66) on the wall section (8).

10. Housing assembly (1) according to one of claims 1 to 9, wherein in the inserted state (2) the locking sub-assembly (10) forms at least one further glue transport channel (70), the at least one further glue transport channel (70) being connected to the at least one glue transport channel (68).

11. Housing assembly (1) according to one of claims 1 to 10, wherein at least one of the glue transport channel (68) and the further glue transport channel (70) is filled with glue (34).

12. Housing assembly (1) according to any one of claims 1 to 11, wherein a front (28) and back (30) of the at least one bulkhead wall (4) are at least partially engaged by the locking sub-assembly (10).

13. Method for assembling a housing (1) for an electrical component (38) such as a relay (40), comprising the steps of inserting at least one bulkhead wall (4) in an insertion direction (S) into a housing part (6), the at least one bulkhead wall (4), in an inserted state (2) extending from one wall section (8) to an opposite wall section (8) along a horizontal direction (H), and
**characterized by** the step of locking the at least one bulkhead wall (4) to the housing part (6) in a direction perpendicular to the insertion direction (S) and parallel to the horizontal direction (H),
and in that in the inserted state (2) at least one glue transport channel (68) is provided, the at least one glue transport channel (68) opening towards an outside of the housing assembly (1) and extending to the locking sub-assembly (10).

14. Method according to claim 13, wherein the method further comprises the step of filling the glue transport channel (68) with glue (34).

## Patentansprüche

1. Gehäusebaugruppe (1), die zum Umschließen eines elektrischen Bauteils (38), wie eines Relais (40), ausgebildet ist, mit einem Gehäuseteil (6) und mindestens einer Schottwand (4),
wobei die mindestens eine Schottwand (4) so konfiguriert ist, dass sie in das Gehäuseteil (6) in einer Einschubrichtung (S) eingeschoben werden kann und sich in einem eingeschobenen Zustand (2) von einem Wandabschnitt (8) des Gehäuseteils (6) zu einem gegenüberliegenden Wandabschnitt (8) entlang einer horizontalen Richtung (H) erstreckt,
**dadurch gekennzeichnet, dass** die Gehäusebaugruppe (1) eine Verriegelungsunterbaugruppe (10) umfasst, die so konfiguriert ist, dass sie die mindestens eine Schottwand (4) an dem Gehäuseteil (6) mindestens in einer Richtung parallel zu der horizontalen Richtung (H) verriegelt
und dass im eingeschobenen Zustand (2) mindestens ein Leimtransportkanal (68) vorgesehen ist, wobei der mindestens eine Leimtransportkanal (68) zu einer Außenseite der Gehäusebaugruppe (1) hin offen ist und sich bis zur Verriegelungsunterbaugruppe (10) erstreckt.

2. Gehäusebaugruppe (1) nach Anspruch 1, wobei die Verriegelungsunterbaugruppe (10) mindestens zwei sich überlappende Vorsprünge (24, 26) aufweist, die sich in horizontaler Richtung (H) überlappen.

3. Gehäusebaugruppe (1) nach Anspruch 1 oder 2, wobei die Verriegelungsunterbaugruppe (10) mindestens eine sich in Einschubrichtung (S) erstreckende Schienenführung (12) zur Führung der mindestens einen Schottwand (4) aufweist.

4. Gehäusebaugruppe (1) nach Anspruch 3, wobei die mindestens eine Schienenführung (12) so ausgebildet ist, dass sie ein relatives Gleiten zwischen dem Gehäuseteil (6) und der mindestens einen Schottwand (4) in der Einschubrichtung (S) ermöglicht und eine Bewegung zumindest parallel zur horizontalen Richtung (H) blockiert.

5. Gehäusebaugruppe (1) nach Anspruch 3 oder 4, wobei die Schienenführung (12) mindestens zwei Rippen (16, 18) umfasst, die senkrecht zur Einschubrichtung (S) und zur horizontalen Richtung (H) voneinander beabstandet sind und zwischen sich eine Kerbe (20) bilden.

6. Gehäusebaugruppe (1) nach Anspruch 5, wobei mindestens eine der mindestens zwei Rippen (16) eine Hinterschneidung (22) bildet, in die der Vorsprung (24) im eingesetzten Zustand (2) eingreifen kann.

7. Gehäusebaugruppe (1) nach einem der Ansprüche 1 bis 6, wobei die mindestens eine Schottwand (4) Teil eines weiteren Gehäuseteils (7) ist, das geeignet ist, zumindest teilweise in dem Gehäuseteil (6) aufgenommen zu werden.

8. Gehäusebaugruppe (1) nach einem der Ansprüche 1 bis 7, wobei die Gehäusebaugruppe (1) im eingesetzten Zustand (2) hermetisch verschlossen ist.

9. Gehäusebaugruppe (1) nach einem der Ansprüche 1 bis 8, wobei der mindestens eine Leimtransportkanal (68) als Nut (66) an dem Wandabschnitt (8) ausgebildet ist.

10. Gehäusebaugruppe (1) nach einem der Ansprüche 1 bis 9, wobei die Verriegelungsbaugruppe (10) im eingeschobenen Zustand (2) mindestens einen weiteren Leimtransportkanal (70) bildet, wobei der mindestens eine weitere Leimtransportkanal (70) mit dem mindestens einen Leimtransportkanal (68) verbunden ist.

11. Gehäusebaugruppe (1) nach einem der Ansprüche 1 bis 10, wobei mindestens einer der Leimtransportkanäle (68) und der weitere Leimtransportkanal (70) mit Leim (34) gefüllt ist.

12. Gehäusebaugruppe (1) nach einem der Ansprüche 1 bis 11, wobei eine Vorderseite (28) und eine Rückseite (30) der mindestens einen Schottwand (4) zumindest teilweise von der Verriegelungsunterbaugruppe (10) erfasst werden.

13. Verfahren zum Zusammenbau eines Gehäuses (1) für ein elektrisches Bauteil (38), wie z.B. ein Relais (40), mit den Schritten des Einsetzens mindestens einer Schottwand (4) in einer Einsetzrichtung (S) in ein Gehäuseteil (6), wobei sich die mindestens eine Schottwand (4) in einem eingesetzten Zustand (2) von einem Wandabschnitt (8) zu einem gegenüberliegenden Wandabschnitt (8) entlang einer horizontalen Richtung (H) erstreckt, und
**gekennzeichnet durch** den Schritt des Verriegelns der mindestens einen Trennwand (4) an dem Gehäuseteil (6) in einer Richtung senkrecht zu der Einschubrichtung (S) und parallel zu der horizontalen Richtung (H),
und dass im eingeschobenen Zustand (2) mindestens ein Leimtransportkanal (68) vorgesehen ist, wobei der mindestens eine Leimtransportkanal (68) zu einer Außenseite der Gehäusebaugruppe (1) hin offen ist und sich bis zur Verriegelungsunterbaugruppe (10) erstreckt.

14. Verfahren nach Anspruch 13, wobei das Verfahren ferner den Schritt des Befüllens des Leimtransportkanals (68) mit Leim (34) umfasst.

## Revendications

1. Ensemble boîtier (1) configuré pour renfermer un composant électrique (38) tel qu'un relais (40), comprenant une partie de boîtier (6) et au moins une paroi de cloison(4),
l'au moins une paroi de cloison (4) étant configurée pour être insérée dans la partie de boîtier (6) dans une direction d'insertion (S) et, dans un état inséré (2), s'étendant d'une section de paroi (8) de la partie de boîtier (6) à une section de paroi opposée (8) le long d'une direction horizontale (H),
**caractérisé en ce que** l'ensemble boîtier (1) comprend un sous-ensemble de verrouillage (10), qui est configuré pour verrouiller l'au moins une paroi de cloison (4) à la partie de boîtier (6) au moins dans une direction parallèle à la direction horizontale (H)
et **en ce que**, à l'état inséré (2), au moins un canal de transport de colle (68) est prévu, l'au moins un canal de transport de colle (68) s'ouvrant vers l'extérieur de l'ensemble boîtier (1) et s'étendant jusqu'au sous-ensemble de verrouillage (10).

2. Ensemble boîtier (1) selon la revendication 1, dans lequel le sous-ensemble de verrouillage (10) comprend au moins deux saillies superposées (24, 26), qui se superposent dans la direction horizontale (H).

3. Ensemble boîtier (1) selon la revendication 1 ou 2, dans lequel le sous-ensemble de verrouillage (10) fournit au moins un guide de rail (12), qui s'étend dans la direction d'insertion (S), pour guider l'au moins une paroi de cloison (4).

4. Ensemble boîtier (1) selon la revendication 3, dans lequel l'au moins un guide de rail (12) est configuré pour permettre un coulissement relatif à l'intérieur, entre la partie de boîtier (6) et l'au moins une paroi de cloison (4) dans la direction d'insertion (S) et pour bloquer le mouvement au moins parallèlement à la direction horizontale (H).

5. Ensemble boîtier (1) selon la revendication 3 ou 4, dans lequel le guide de rail (12) comprend au moins deux nervures (16, 18) espacées l'une de l'autre perpendiculairement à la direction d'insertion (S) et à la direction horizontale (H) et formant une encoche (20) entre elles.

6. Ensemble boîtier (1) selon la revendication 5, dans lequel au moins l'une des au moins deux nervures (16) forme une contre-dépouille (22) adaptée pour être engagée par la saillie (24) dans l'état inséré (2).

7. Ensemble boîtier (1) selon l'une quelconque des revendications 1 à 6, dans lequel l'au moins une paroi de cloison (4) fait partie d'une partie de boîtier supplémentaire(7), qui est adaptée pour être au moins partiellement reçue dans la partie de boîtier (6).

8. Ensemble boîtier (1) selon l'une quelconque des revendications 1 à 7, dans lequel, à l'état inséré (2), l'ensemble boîtier (1) est scellé hermétiquement.

9. Ensemble boîtier (1) selon l'une des revendications 1 à 8, dans lequel l'au moins un canal de transport de colle (68) se présente sous forme de rainure (66) sur la section de paroi (8).

10. Ensemble boîtier (1) selon l'une des revendications 1 à 9, dans lequel, à l'état inséré (2), le sous-ensemble de verrouillage (10) forme au moins un canal de transport de colle supplémentaire (70), l'au moins un canal de transport de colle supplémentaire (70) étant relié à l'au moins un canal de transport de colle (68).

11. Ensemble boîtier (1) selon l'une des revendications 1 à 10, dans lequel au moins l'un parmi le canal de transport de colle (68) et le canal de transport de colle supplémentaire (70) est rempli de colle (34).

12. Ensemble boîtier (1) selon l'une quelconque des revendications 1 à 11, dans lequel une partie avant (28) et une partie arrière (30) de l'au moins une paroi de cloison (4) sont au moins partiellement engagées par le sous-ensemble de verrouillage (10).

13. Procédé d'assemblage d'un boîtier (1) pour un composant électrique (38) tel qu'un relais (40), comprenant l'étape consistant à insérer au moins une paroi de cloison (4) dans une direction d'insertion (S) dans une partie de boîtier (6), l'au moins une paroi de cloison (4), dans un état inséré (2) s'étendant d'une section de paroi (8) à une section de paroi opposée (8) le long d'une direction horizontale (H), et
**caractérisé par** l'étape consistant à verrouiller l'au moins une paroi de cloison (4) sur la partie de boîtier (6) dans une direction perpendiculaire à la direction d'insertion (S) et parallèle à la direction horizontale (H),
et en ce que, à l'état inséré (2), au moins un canal de transport de colle (68) est prévu, ledit au moins un canal de transport de colle (68) s'ouvrant vers l'extérieur de l'ensemble boîtier (1) et s'étendant jusqu'au sous-ensemble de verrouillage (10).

14. Procédé selon la revendication 13, dans lequel le procédé comprend en outre l'étape consistant à remplir le canal de transport de colle (68) avec de la colle (34).
